# EUROPEAN PATENT APPLICATION

(11) **EP 2 367 409 A2**
(43) Date of publication of application: **21.09.2011**
(21) Application number: 10189930.0
(22) Date of filing: 04.11.2010
(51) Int. Cl.: H05K 5/02, G06F 1/16

(54) **Stand for information processing apparatus**

(30) Priority: 25.02.2010 JP 2010040188
(71) Applicant: Toshiba TEC Kabushiki Kaisha, Tokyo 141-8664 (JP)
(72) Inventor: Sekino, Toshiharu, Shinagawa-ku Tokyo 141-8664 (JP)
(74) Representative: Gendron, Vincent Christian

(57) **Abstract**

A stand (10) for an information processing apparatus includes a supporting member (11) supporting the information processing apparatus from a side thereof, and a coupling member (13) having protrusions (14) and recesses (15) on a first side thereof, which are spaced at a certain interval and have shapes engageable with each other. The stand (10) also includes a protruding member (12) provided on an end of the coupling member (13) and that protrudes from the supporting member (11) in a direction opposite to the coupling member (13).

## Description

### FIELD

Embodiments described herein relate generally to a turnover prevention stand for an information processing apparatus adaptable to information processing apparatuses with a various range of thicknesses.

### BACKGROUND

A housing of an information processing apparatus such as personal computers (PCs) and point-of-sale (POS) terminals generally has a different thickness depending on the type of apparatus. Thus, whenever a new type of information processing apparatus is released, a stand for preventing apparatus from being turned over should be newly designed and casted in a die, resulting in increased manufacturing cost.

In this regard, a technology has been proposed for clamping an information processing apparatus in which clamping parts are rotatably coupled to each other and the apparatus is supported by the clamping parts with the apparatus being placed on the coupling part.

However, this technology has is limited by the range of the widths of the apparatus that can be supported by the clamping parts. That is, it is problematic if the width of the apparatus has excessive dimensions, which makes the clamping parts open upwards and thus makes the vertical posture support unstable. In contrast, if the width has excessively small dimensions, the clamping distance formed by the clamping parts is not be narrow enough to firmly clamp the apparatus because the operation of the coupling part is obstructed by a supporting table on which the apparatus is placed.

### BRIEF DESCRIPTION OF THE DRAWINGS

**FIG. 1** is a perspective bottom view showing a stand for an information processing apparatus according to a first embodiment.

**FIG. 2** is a view showing an exemplary use of the stand in an information processing apparatus having a relatively-small width.

**FIG. 3** is a view showing an exemplary use of the stand in the information processing apparatus having a relatively-small width.

**FIG. 4** is a view showing an exemplary use of the stand in the information processing apparatus having a relatively-small width.

**FIG. 5** is a view showing an exemplary use of the stand in an information processing apparatus having a relatively-large width.

**FIG. 6** is a view showing an exemplary use of the stand in the information processing apparatus having a relatively-large width.

**FIG. 7** is a view showing an exemplary use of the stand in the information processing apparatus having a relatively-large width.

**FIG. 8** is a view showing the stand of the first embodiment having an elastic member.

**FIG. 9** is a front view showing an assembly of two stands of the first embodiment.

**FIG. 10** is a perspective bottom view showing the stand having an elastic member.

**FIG. 11** is a perspective view showing a stand for an information processing apparatus according to a second embodiment.

**FIG. 12** is a view showing the stand of the second embodiment in which a distance between supporting members is shortened.

**FIG. 13** is a perspective view showing a stand for an information processing apparatus according to a third embodiment.

**FIG. 14** is a view showing the stand of the third embodiment in which a distance between supporting members is widened.

**FIG. 15** is a front view showing the stand of the third embodiment.

**FIG. 16** is a rear view showing the stand of the third embodiment.

**FIG. 17** is a plan view showing the stand of the third embodiment.

**FIG. 18** is a bottom view showing the stand of the third embodiment.

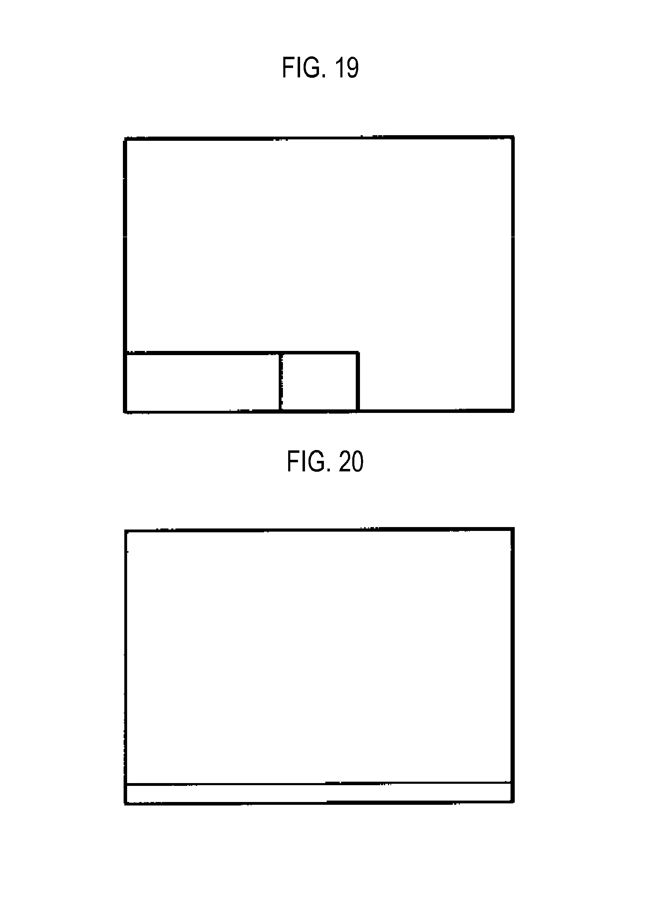

**FIG. 19** is a right side view showing the stand of the third embodiment.

**FIG. 20** is a left side view showing the stand of the third embodiment.

**FIG. 21** is a view showing an application example of the stand of the third embodiment.

**FIG. 22** is a view showing an application example of the stand of the third embodiment.

### DETAILED DESCRIPTION

According to one embodiment, a stand for an information processing apparatus includes a supporting member supporting the information processing apparatus from a side thereof, and a coupling member having protrusions and recesses on a first side thereof, which are spaced at a certain interval and have shapes engageable with each other. The stand also includes a protruding member provided on an end of the coupling member and protruded from the supporting member in a direction opposite to the coupling member.

Embodiments of a stand for an information processing apparatus will now be described with reference to the accompanying drawings. Here, the information processing apparatus includes personal computers (PCs) and point-of-sale (POS) terminals.

### <First Embodiment>

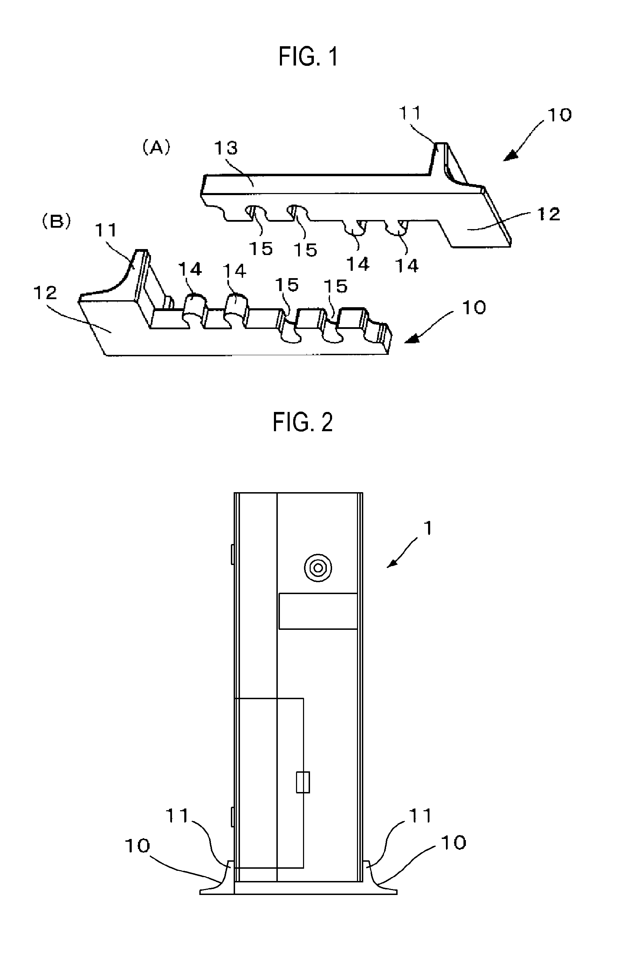

**FIG. 1** is a perspective bottom view of a stand 10 for an information processing apparatus according to the first embodiment. A portion A of **FIG. 1** illustrates a perspective view as seen from the bottom side, while a portion B of **FIG. 1** is a perspective view as seen from the front side. As show in **FIG. 1****,** respective stands 10 include a supporting member 11 for supporting an information processing apparatus from the side section, a protruding member 12 for preventing the information processing apparatus from turning over, and a coupling member 13 for coupling two stands 10 with each other.

The supporting member 11 is formed between the coupling member 13 and the protruding member 12, and has a plate shape that extends upwards from a bottom side thereof.

The protruding member 12 is provided on one end of the coupling member 13 and has a plane part that is parallel with a surface on which the stand 10 is installed. The protruding member 12 is provided on one end of the coupling member 13 and protruded from the supporting member 11 in a direction opposite to the coupling member 13.

The coupling member 13 has a plurality of protrusions 14 and recesses 15, which are spaced at regular intervals, respectively. The protrusions 14 and recesses 15 have shapes engageable with each other.

In **FIG. 1****,** the two protrusions 14 are provided on a part of the coupling member 13 on the side of the protruding member 12, while the two recesses 15 are provided on the other part of the coupling member 13.

The protrusion 14 has an engaging part, a width of which is wider than that of a root portion of the protrusion 14 coupled to the coupling member 13. When the protrusion 14 is engaged with the recess 15, the engaging part prevents the protrusion 14 from being easily disengaged from the recess 15 even when a force is applied thereto from the transverse direction.

The protrusions 14 and the recesses 15 are provided on one side of the coupling member 13. Two stands are coupled by placing the protrusions 14 and the recesses 15 of one stand exactly above the corresponding recesses and protrusions of the other stand. Subsequently, the two stands are vertically moved towards each other so as to engage the protrusions 14 of one stand with the recesses 15 of the other stand.

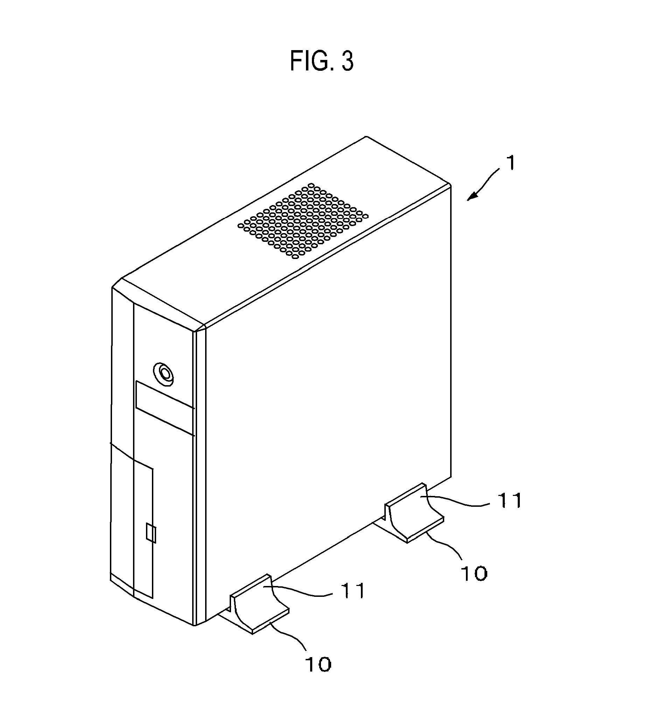

**FIGS. 2** to **4** are views showing an exemplary use of the stand in an information processing apparatus having a relatively-small width. In particular, **FIGS. 2** to **4** illustrate a front view, a perspective view, and a perspective bottom view of the stand used in the information processing apparatus, respectively. As shown in **FIGS. 2** to **4****,** a set of two stands 10 are engaged with each other. As such, generally a pair of stands are used for a single information processing apparatus 1.

The information processing apparatus 1 is installed between a pair of the supporting members 11 to place the apparatus on the stands 10.

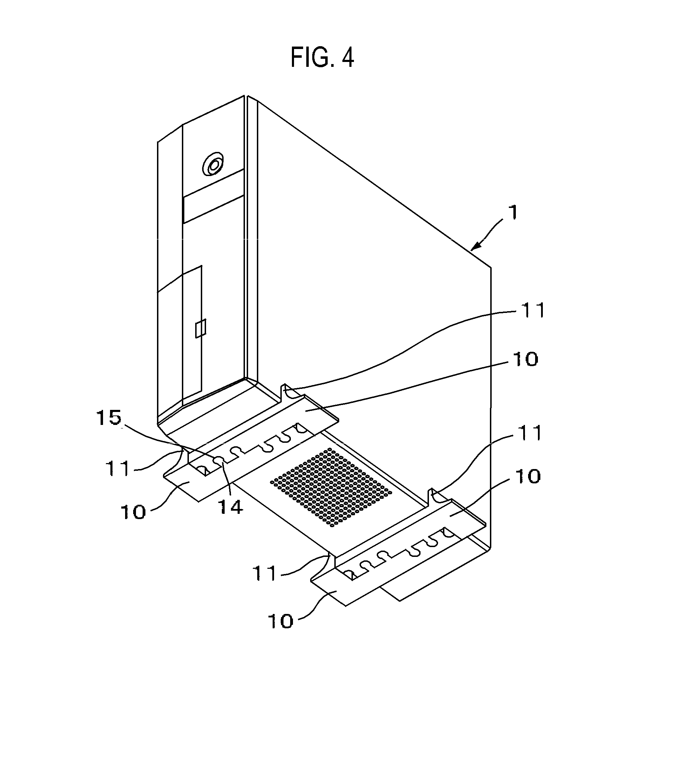

As shown in **FIG. 4****,** to support the information processing apparatus 1 having a relatively-small width, the number of protrusions 14 and recesses 15 in the two stands 10, which are engaged with each other, is increased. In **FIG. 4****,** a total of four pairs of protrusions 14 and recesses 15 are engaged with each other.

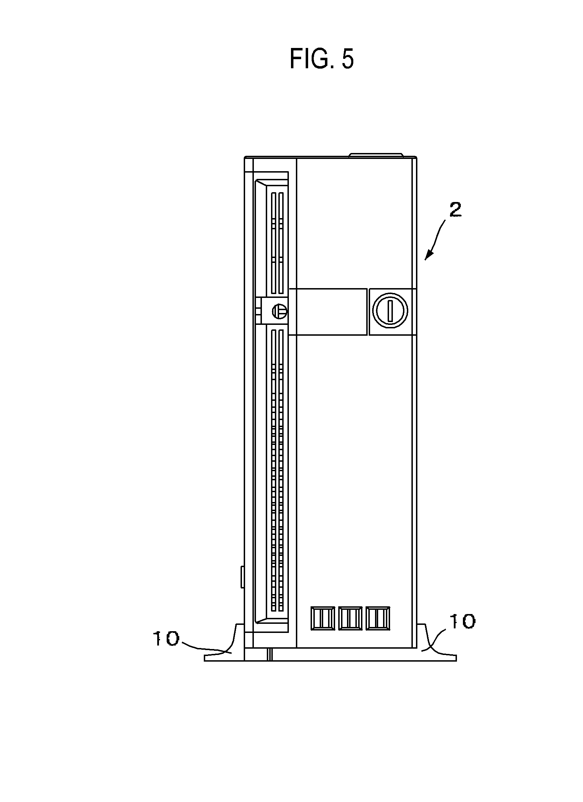

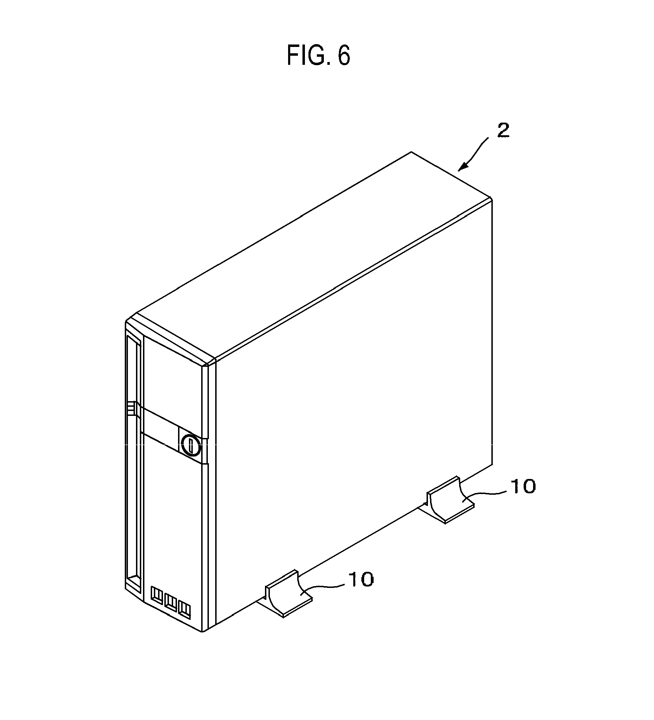

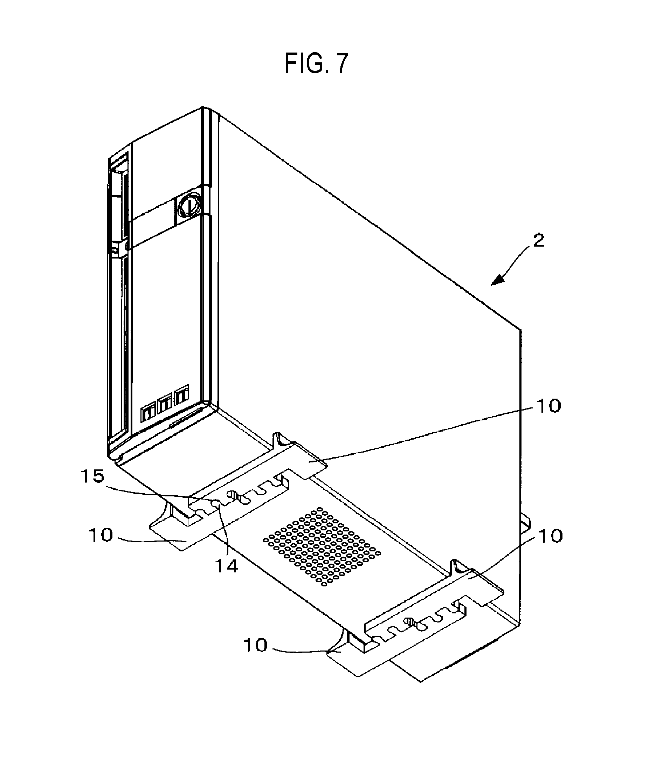

**FIGS. 5** to **7** are views showing an exemplary use of the stand in an information processing apparatus having a relatively-large width. In particular, **FIGS. 5** to **7** illustrate a front view, a perspective view, and a perspective bottom view of the stand used in the information processing apparatus, respectively. As shown in **FIGS. 5** to **7****,** to support the information processing apparatus 2 having a relatively-large width, the number of protrusions 14 and recesses 15 in the two stands 10, which are engaged with each other, is reduced. In **FIG. 7****,** a total of two pairs of protrusions 14 and recesses 15 are engaged with each other.

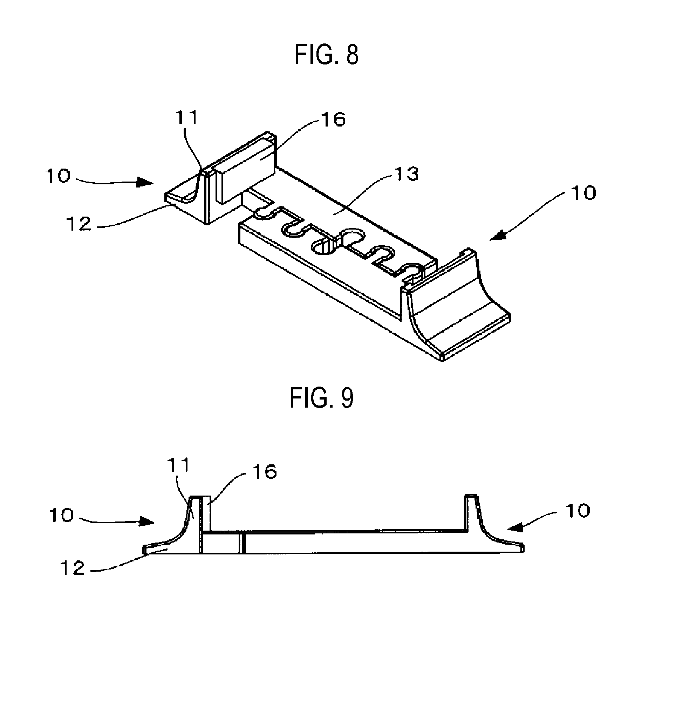

**FIG. 8** is a perspective view showing the stand 10 having an elastic member 16. As shown in **FIG. 8****,** the stand 10 includes the elastic member 16 on one side of the supporting members 11 facing the coupling member 13, i.e. on the side of the supporting member 11 facing an information processing apparatus 3. The elastic member 16 is an elastic body such as rubber, elastic resin, springs or the like.

**FIG. 9** is a front view showing an assembly of two stands 10. As shown in **FIG. 9****,** only one of the two stands 10 is provided with the elastic member 16.

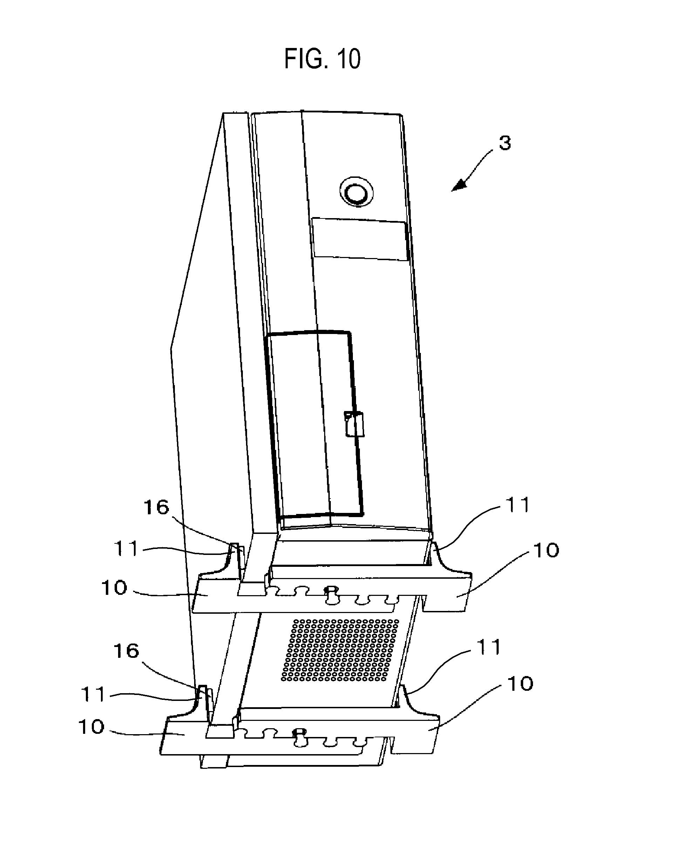

**FIG. 10** is a perspective bottom view showing an exemplary use of the stand 10 having the elastic member 16. As shown in **FIG. 10****,** to fill a gap formed between the supporting member 11 and the information processing apparatus 3 when the two stands 10 are coupled to each other, the elastic member 16 is installed onto one or both of the two stands 10.

The thickness of the elastic member 16 is equal to or larger than the thickness obtained by subtracting a width of the information processing apparatus 3 from a distance between the respective supporting members 11 of the two stands 10.

As described above, the stand 10 for an information processing apparatus includes the supporting member 11 that supports the information processing apparatus from the side section, the protruding member 12 that prevents the apparatus from turning over, and the coupling member 13 having the protrusions 14 and the recesses 15, which are spaced at a certain interval and have shapes engageable with each other.

Thus, in the present embodiment, the stand 10 can be provided to be applicable to various information processing apparatuses having different thicknesses, at low cost, using a single die.

### <Second Embodiment>

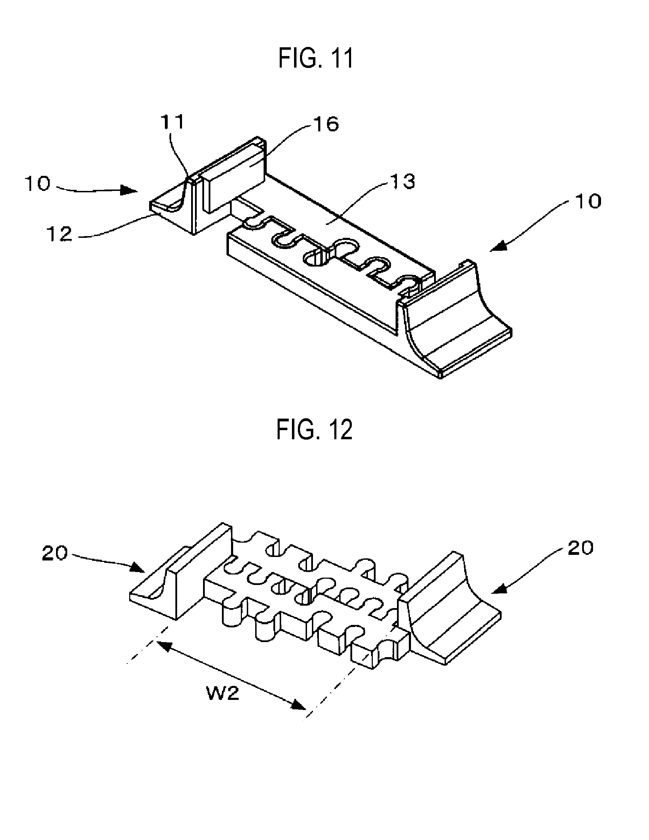

**FIG. 11** is a perspective view showing a stand 20 for an information processing apparatus according to the second embodiment. As shown in **FIG. 11****,** the respective stands 20 include a supporting member 21 that supports the information processing apparatus from the side section, a protruding member 22 that prevents the information processing apparatus from turning over, and a coupling member 23 that couples two stands 20 with each other.

The supporting member 21 is located between the coupling member 23 and the protruding member 22, and has a plate shape that extends upwards.

The protruding member 22 is provided on one end of the coupling member 23 and has a plane part that is parallel with a surface on which the stand 20 is installed. The protruding member 22 is provided on one end of the coupling member 23 and protrudes from the supporting member 21 in a direction opposite to the supporting member 21.

The coupling member 23 has on a first side face thereof a plurality of protrusions 24 and recesses 25, which are spaced at a certain interval, respectively. The protrusions 24 and recesses 25 have shapes engageable with each other.

Further, the coupling member 23 has, on a second side face thereof opposite to the first side face, a plurality of protrusions 26 and recesses 27, which are spaced at a certain interval, respectively. The interval between the protrusions 26 (or the recesses 27) on the second side face is arranged to be different from the interval between the protrusions (or the recesses) on the first side face. The protrusions 26 and recesses 27 have shapes engageable with each other.

In **FIG. 11****,** on the first side face of the coupling member 23, the two protrusions 24 are arranged on a part of the coupling member 23 on the side of the protruding member 22, while the two recesses 25 are arranged on the other part of the coupling member 23. In the meantime, on the second side face of the coupling member 23, the four recesses 27 are arranged on a part of the coupling member 23 on the side of the protruding member 22, while the two protrusions 26 are provided on the other part of the coupling member 23.

Each of the protrusions 24 and 26 has an engaging part, a width of which is wider than that of a root portion of the protrusion 24 coupled to the coupling member 23. When the protrusions 24 and 26 are engaged with the recesses 25 and 27, respectively, the engaging parts prevent the protrusions 24 and 26 from being easily disengaged from the recesses 25 and 27 even when a force is applied thereto in the transverse direction.

The protrusions 24 and the recesses 25 are provided on the first side face of the coupling member 23. Accordingly, if the first side face of the first stand 20 is aligned to face the first side face of the second stand 20, then the protrusions 24 of one stand 20 are also aligned to face the recesses 25 of the other stand 20. Then, the two stands 20 are vertically moved towards each other so as to engage the protrusions 24 with the recesses 25.

In case the two stands 20 are coupled to each other by engaging the protrusions 24 with the recesses 25, the space formed by the stands 20 does not fit with the width of the information processing apparatus to be installed. In this case, the protrusions 26 and the recesses 27 are arranged to engage them with each other.

The protrusions 26 and the recesses 27 are provided on the second side face of the coupling member 23. Thus, as shown in **FIG. 11****,** if the second side face of the first stand 20 is aligned to face the second side face of the second stand 20, then the protrusions 26 of one stand 20 are also aligned to face the recesses 27 of the other stand 20. Then, the two stands 20 are vertically moved towards each other so as to engage the protrusions 26 with the recesses 27.

As shown in **FIG. 11****,** to support the information processing apparatus having a relatively-large width, the protrusions 26 and the recesses 27 of the two stands 20 are engaged so as to have a large distance between a pair of the supporting members 21 . In **FIG. 11****,** the distance between the supporting members 21 is indicated as W1.

**FIG. 12** is a view of the two stands coupled to each other, where the distance between supporting members 21 is shortened compared to the embodiment shown in **FIG. 11****.** As shown in **FIG. 12****,** to support the information processing apparatus having a relatively-small width, more protrusions 26 are engaged with more recesses 27 that are closer to the supporting member 21. In this way, the two stands 20 are coupled to each other so that the distance between the supporting members 21 is shortened. In **FIG. 12****,** the distance between the supporting members 21 is indicated as W2, which is smaller than W1.

As described above, the stand 20 for an information processing apparatus includes the supporting member 21 that supports the information processing apparatus from the side section, the protruding member 22 that prevents the information processing apparatus from turning over, and the coupling member 23. The coupling member 23 has on the first side face thereof the plurality of protrusions 24 and recesses 25, which are spaced at a certain interval, respectively. Also, the protrusions 24 and recesses 25 have shapes engageable with each other. On the other hand, the coupling member 23 has, on the second side face opposite to the first side face, the plurality of protrusions 26 and recesses 27, which are spaced at a certain interval, respectively. The interval between the protrusions 26 (or the recesses 27) is arranged to be different from the interval between the protrusions (or the recesses) on the first side face. Also, the protrusions 26 and recesses 27 have shapes engageable with each other.

Thus, in the present embodiment, the stand 20 can be provided to be applicable to various information processing apparatuses having different thicknesses, at low cost, using a single die.

### <Third Embodiment>

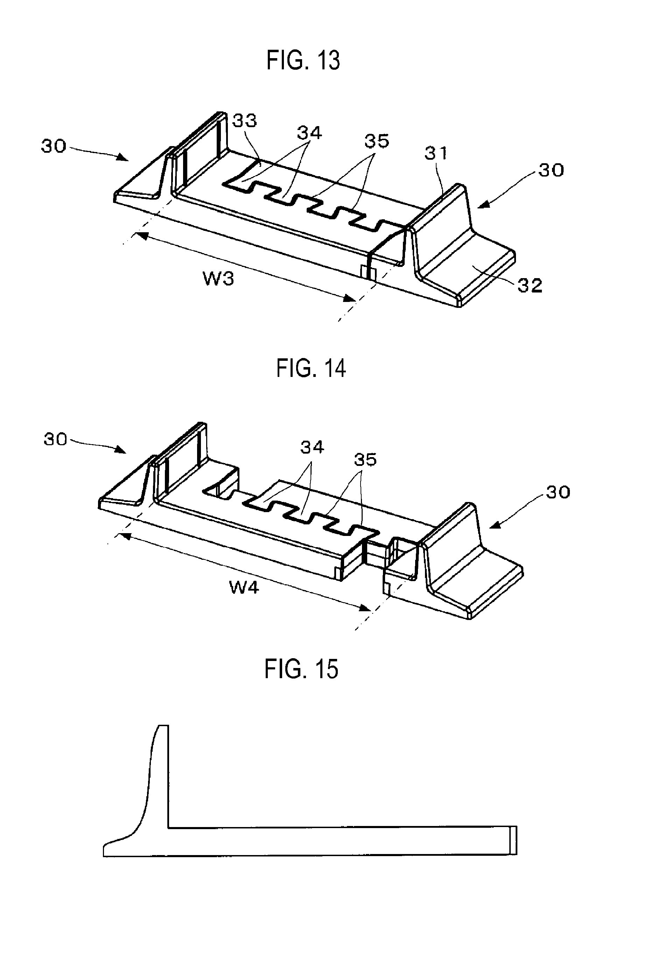

**FIG. 13** is a perspective view showing a stand 30 for an information processing apparatus according to the embodiment. As shown in **FIG. 13****,** the stand 30 includes a supporting member 31 that supports the information processing apparatus from the side section, a protruding member 32 that prevents the information processing apparatus from turning over, and a coupling member 33 that couples two stands 30 with each other.

The supporting member 31 is located between the coupling member 33 and the protruding member 32, and has a plate shape that extends upwards.

The protruding member 32 is provided on one end of the coupling member 33 and has a plane part that is parallel with a surface on which the stand 30 is installed. The protruding member 32 is provided on one end of the coupling member 33 and protrudes in a direction opposite to the supporting member 31.

The coupling member 33 has on a side face thereof a plurality of protrusions 34 and recesses 35, which are alternately placed at a certain interval. The protrusions 34 and recesses 35 have shapes engageable with each other.

In **FIG. 13****,** the four protrusions 34 and four recesses 35 are alternately provided on one side face of the coupling member 33.

Each of the protrusions 34 has an engaging part, a width of which is wider than that of a root portion of the protrusion 34 coupled to the coupling member 33. When the protrusions 34 are engaged with the recesses 35, the engaging parts prevent the protrusions 34 from being easily disengaged from the recesses 35 even when a force is applied thereto in the transverse direction.

The protrusions 34 and the recesses 35 are provided on one side face of the coupling member 33. Accordingly, the side face of the first stand 30 is aligned to face with the side face of the second stand 30. Then, the two stands are vertically moved towards each other so as to engage the protrusions 34 with the recesses 35.

As shown in **FIG. 13****,** to support an information processing apparatus having a relatively-small width, the protrusions 34 are engaged with the recesses 35 so as to couple the two stands 30 to each other with a short distance between the pair of supporting members 31. That is, the two stands 30 are coupled to each other by engaging a larger number of the protrusions 34 with the corresponding recesses 35. In **FIG. 13****,** a total of eight pairs of protrusions 34 and recesses 35 are engaged with each other. Also, in **FIG. 13****,** the distance between the supporting members 31 is indicated as W3.

**FIG. 14** is a perspective view of the two stands coupled to each other, where the distance between supporting members 31 is shortened compared to the embodiment of **FIG. 13****.** As shown in **FIG. 14****,** to support the information processing apparatus having a relatively-large width, two stands 30 are coupled to each other by engaging a smaller number of the protrusions 34 with the corresponding recesses 35. In **FIG. 14****,** a total of six pairs of protrusions 34 and recesses 35 are engaged with each other. Also, in **FIG. 14****,** the distance between the supporting members 31 is indicated as W4, which is wider than W3.

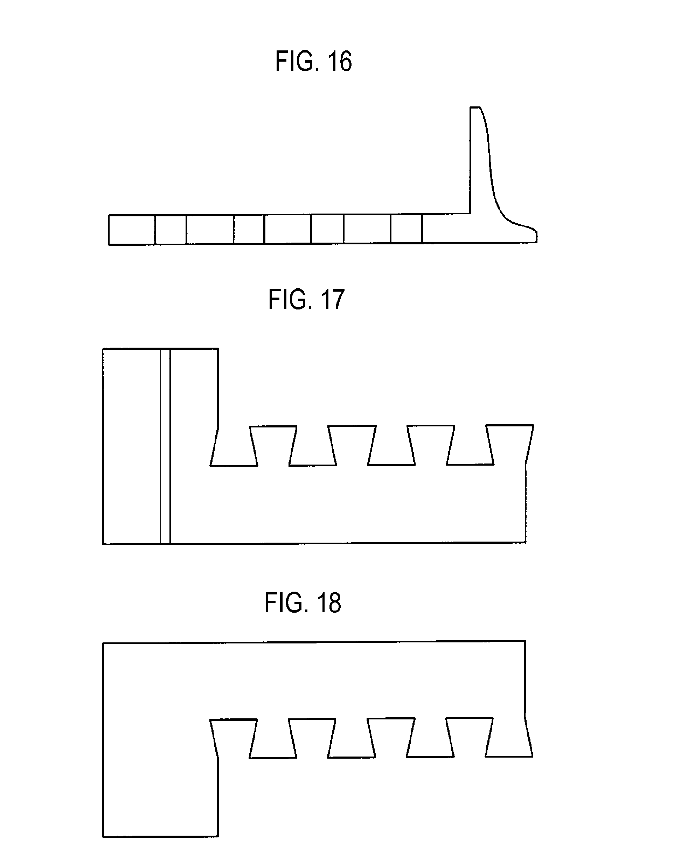

**FIGS. 15** to **18** illustrate a front view, a rear view, a plan view, and a bottom view of the stand 30, respectively. Further, **FIG.S. 19** and **20** illustrate a right side view and a left side view of the stand 30, respectively.

The stand 30 for an information processing apparatus is employed to prevent an information processing apparatus, such as personal computers (PCs), point-of-sale (POS) terminals, or the like, from being turned over. One set of the stands include a pair of stands, such that the two stands are coupled to each other by engaging the protrusions 34 with the corresponding recesses 35. In some embodiments, two sets of stands are employed to support an information processing apparatus between the supporting members 31 of respective stands.

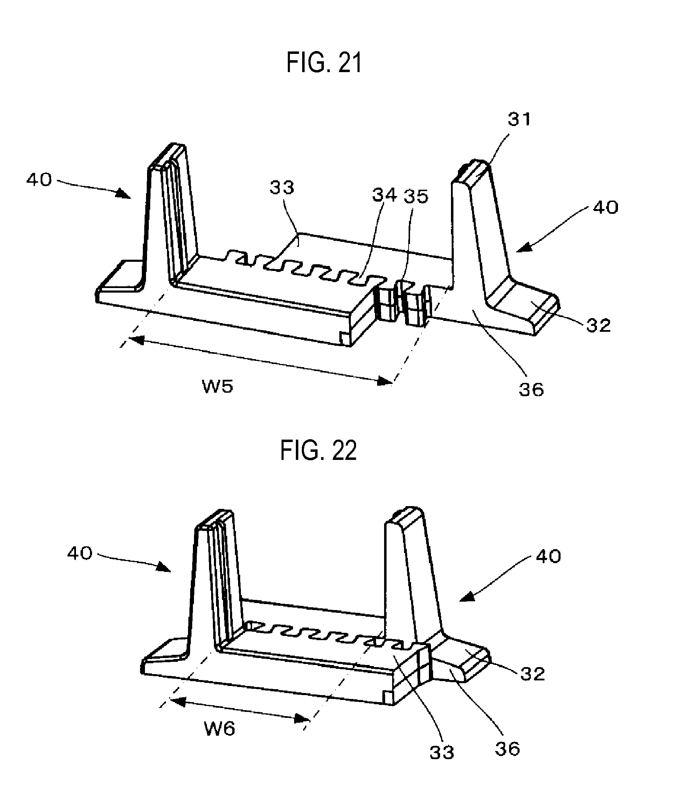

**FIGS. 21** and **22** are perspective views of a stand 40 according to an alternate example of the embodiment. As shown in **FIG. 21****,** the stand 40 includes a protruding member 32 which has a notch portion 36. The notch portion 36 is coupled to a recess 35 arranged at a position nearest to the supporting member 31, i.e. the recess 35 that is closest to the supporting member 31. The notch portion 36 is notched to a depth that is equal to or larger than the depth of the recess 35.

As shown in **FIG. 21****,** to support the information processing apparatus having a relatively-large width, two stands 40 are coupled by engaging the recesses 35 with the protrusions 34 so as to have a large distance between the pair of supporting members 31. In **FIG. 21****,** the distance between the supporting members 31 is indicated as W5.

On the other hand, as shown in **FIG. 22****,** to support the information processing apparatus having a relatively-small width, two stands 40 are coupled by engaging the recesses 35 with the protrusions 34 so as to have a short distance between the pair of supporting members 31. In **FIG. 22****,** the distance between the supporting members 31 is indicated as W6, which is smaller than W5.

In the present embodiment, since the protruding member 32 has the notch portion 36, the protrusions 34 and the recesses 35 of two stands are engaged with each other so that the coupling member 33 of one stand can protrude out of the protruding member 32 of the other stand. Accordingly, the present embodiment is applicable to an information processing apparatus that has a smaller width.

As described above, the stands 30 and 40 of the present embodiment include the supporting member 31 that supports the information processing apparatus from the side section, the protruding member 32 that prevents the information processing apparatus from turning over, and the coupling member 33 that has the protrusions 34 and the recesses 35 which are alternately arranged so as to be spaced at a certain interval and have shapes engageable with each other.

Thus, in the present embodiment, the stands 30 and 40 are able to be used with various information processing apparatuses having different thicknesses, at low cost, using a single die.

While certain embodiments have been described, these embodiments have been presented by way of example only, and are not intended to limit the scope of the inventions. Indeed, the embodiments described herein may be embodied in a variety of other forms; furthermore, various omissions, substitutions and changes in the form of the embodiments described herein may be made without departing from the inventions. The accompanying claims and their equivalents are intended to cover such forms or modifications as would fall within the scope of the inventions.

## Claims

1. A stand (10) for an information processing apparatus, comprising:
a supporting member (11) configured to support the information processing apparatus from a side of the supporting member (11);
a coupling member (13) comprising protrusions (14) and recesses (15) on a first side of the coupling member (13), the protrusions (14) and recesses (15) spaced apart at a certain interval, respectively, and having shapes engageable with each other; and
a protruding member (12) provided on an end of the coupling member (13), the protruding member (12) extending from the supporting member (11) in a direction opposite to the coupling member (13).

2. The stand of Claim 1, wherein the supporting member (11) is provided between the coupling member (13) and the protruding member (12), and the supporting member (11) has a plate shape that extends upwards from a bottom side of the supporting member (11).

3. The stand (10) of Claim 1, wherein the protruding member (12) is provided on one end of the coupling member (13) and has a plane part that is parallel with a surface on which the stand is installed.

4. The stand (10) of Claim 1, wherein the protrusions (14) are provided on a part of the coupling member (13) on the side of the protruding member (12), and the recesses (15) are provided on the other part of the coupling member (13).

5. The stand (10) of Claim 1, wherein the protrusions (14) respectively have an engaging part, the engaging part having a width of which is wider than the width of a root portion of the protrusion (14).

6. The stand (10) of Claim 1, wherein the stand (10) further comprises an elastic member (16) on one side of the supporting members (11) facing the coupling member (13).

7. The stand (10) of Claim 6, wherein the elastic member (16) comprises an elastic body formed of one selected from a group essentially consisting of rubber, elastic resin and springs.

8. The stand (20) of Claim 1, wherein the coupling member (23) further comprises, on a second side of the coupling member (23) facing opposite to the first side, protrusions (26) and recesses (27), which are spaced at a certain interval different from the interval on the first side, and have shapes engageable with each other.

9. The stand (20) of Claim 8, wherein on the first side face of the coupling member (23), the protrusions (24) are arranged on a part of the coupling member (23) on the side of the protruding member (22), and the recesses (25) are arranged on the other part of the coupling member (23), and
wherein on the second side face of the coupling member (23), the recesses (27) are arranged on a part of the coupling member (23) on the side of the protruding member (22), and the protrusions (26)are provided on the other part of the coupling member (23).

10. The stand (30) of Claim 1, wherein the coupling member (33) comprises, on the first side, protrusions (34) and recesses (35), which are alternately arranged so as to be spaced at a certain interval and have shapes engageable with each other.

11. The stand (30) of Claim 1, wherein the protruding member (32) comprises a notch portion (36) that is coupled with one of the recesses (35) nearest to the supporting member (31) and is notched to a depth that is equal to or larger than the depth of the recess (35).
